(19) Europäisches Patentamt
European Patent Office
Office européen des brevets

(11) **EP 4 226 170 B1**

(12) **EUROPÄISCHE PATENTSCHRIFT**

(45) Veröffentlichungstag und Bekanntmachung des Hinweises auf die Patenterteilung:
**07.08.2024 Patentblatt 2024/32**

(21) Anmeldenummer: **21786089.9**

(22) Anmeldetag: **24.09.2021**

(51) Internationale Patentklassifikation (IPC):
**G01R 33/44** $^{(2006.01)}$ **G01N 24/08** $^{(2006.01)}$
**G07D 7/00** $^{(2016.01)}$ **G01R 33/3415** $^{(2006.01)}$
**G01R 33/36** $^{(2006.01)}$ **G07D 1/00** $^{(2006.01)}$
**G07D 7/04** $^{(2016.01)}$

(52) Gemeinsame Patentklassifikation (CPC):
**G01R 33/441; G01N 24/08; G07D 7/04;**
G01R 33/3415; G01R 33/3635; G01R 33/3657

(86) Internationale Anmeldenummer:
**PCT/EP2021/025367**

(87) Internationale Veröffentlichungsnummer:
**WO 2022/073635 (14.04.2022 Gazette 2022/15)**

(54) **VORRICHTUNG ZUR ECHTHEITSPRÜFUNG EINES DATENTRÄGERS MIT NULLFELD-NMR-MERKMAL**

DEVICE FOR CHECKING THE AUTHENTICITY OF A DATA CARRIER HAVING A ZERO-FIELD NMR FEATURE

DISPOSITIF DE CONTRÔLE D'AUTHENTICITÉ D'UN SUPPORT DE DONNÉES À CARACTÉRISTIQUE RMN À CHAMP NUL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.10.2020 DE 102020006201**

(43) Veröffentlichungstag der Anmeldung:
**16.08.2023 Patentblatt 2023/33**

(73) Patentinhaber: **Giesecke+Devrient Currency Technology GmbH**
**81677 München (DE)**

(72) Erfinder: **HUBER, Stephan**
**80634 München (DE)**

(74) Vertreter: **Giesecke+Devrient IP**
**Prinzregentenstraße 161**
**81677 München (DE)**

(56) Entgegenhaltungen:
CN-U- 204 269 802    ES-A1- 2 354 658
US-A1- 2014 070 810    US-B2- 7 388 377
US-B2- 7 481 428    US-B2- 9 696 397

**Beschreibung**

Die Erfindung betrifft eine Vorrichtung zur Echtheitsprüfung eines flächigen Datenträgers mit einem Nullfeld-Kernspinresonanz (NMR)-Merkmal.

Datenträger, wie Wert- oder Ausweisdokumente, aber auch andere Wertgegenstände, wie etwa Markenartikel, werden zur Absicherung oft mit Sicherheitselementen versehen, die eine Überprüfung der Echtheit der Datenträger gestatten und die zugleich als Schutz vor unerlaubter Reproduktion dienen.

Um eine automatische Echtheitsprüfung und gegebenenfalls eine weitergehende sensorische Erfassung und Bearbeitung der damit versehenen Datenträger zu ermöglichen, sind die Sicherheitselemente oft maschinenlesbar ausgebildet. Für diesen Zweck werden seit langem Sicherheitselemente mit maschinenlesbaren magnetischen Bereichen eingesetzt, deren Informationsgehalt bei der Echtheitsprüfung von dem Magnetsensor eines Bearbeitungssystems erfasst und ausgewertet werden kann.

Seit einiger Zeit werden auch Sicherheitselemente mit Kernspinresonanz-Merkmalen zur Absicherung von Dokumenten und anderen Datenträgern eingesetzt, wie beispielsweise in der Druckschrift EP 2 778 705 A1 beschrieben.

Kernspinresonanz (Nuclear Magnetic Resonance, NMR) bezeichnet einen physikalischen Effekt, bei dem die Atomkerne einer Probe in einem konstanten Magnetfeld $B_0$ elektromagnetische Wechselfelder absorbieren und emittieren. Die Kernspins präzedieren dabei mit einer zu Magnetfeldstärke $B_0$ proportionalen Larmor-Frequenz $\omega_L$ um die Achse des konstanten Magnetfelds. Durch einen geeigneten resonanten Anregungspuls einer Anregungsspule kann die makroskopische Magnetisierung der Probe aus der z-Richtung des konstanten Magnetfelds in die xy-Ebene gekippt werden.

Die ausgelenkte Magnetisierung $M_{xy}$ rotiert dann mit der Larmor-Frequenz um die z-Achse und induziert dabei in einer Empfangsspule - die mit der Anregungsspule identisch sein kann - eine messbare Spannung. Diese makroskopisch messbare Spannung nimmt aufgrund von Inhomogenitäten im $B_0$-Feld mit einer gewissen Zeitkonstante (T2*) ab, was als freier Induktionszerfall (Free-Induction-Decay, FID) bezeichnet wird. In eingeschränktem Maße ist die zugrundliegende Dephasierung der magnetischen Momente der einzelnen Kerne allerdings reversibel. Legt man nämlich zu einem Zeitpunkt TE/2 einen 180°-Puls an, also einen Anregungspuls, der so gewählt ist, dass die Magnetisierung um 180° gedreht wird, so entsteht zur Echozeit TE ein sogenanntes Spin-Echo, das sich durch einen elektromagnetischen Puls in der Empfangsspule messen lässt.

Durch Hintereinanderschalten mehrerer, um TE getrennter 180°-Pulse entsteht ein Zug von Spin-Echos, deren Amplitude aufgrund von Spin-Spin Wechselwirkungen mit einer Zeitkonstante T2 abnimmt. Parallel dazu baut sich mit einer charakteristischen Zeitkonstante T1 die Gleichgewichtsmagnetisierung entlang der z-Achse wieder auf.

NMR-Anwendungen sind in der medizinischen Bildgebung und der chemischen Strukturanalyse seit langem weit verbreitet, erfordern allerdings in der Regel ein starkes statisches Magnetfeld $B_0$, um eine messbare Magnetisierung zu induzieren.

Für die Anwendung in der Dokumentensicherheit sind sogenannte Nullfeld-NMR-Techniken, wie etwa die Nuklear-Quadrupol-Resonanz (NQR) oder NMR in Ferromagnetika (NMR-FM) von besonderem Interesse. Diese benötigen kein externes Magnetfeld $B_0$, sondern dieses Feld liegt durch intrinsische Effekte im Kristall bereits vor. Dies erlaubt eine signifikante Vereinfachung des Messaufbaus und macht eine Nullfeld-NMR-Substanz auch als Sicherheitsmerkmal in Wertdokumenten wie Banknoten, Karten, Pässen oder Patches interessant.

Die genannte Druckschrift EP 2 778 705 A1 offenbart eine Sicherheitsmarkierung für Banknoten mit einer Nullfeld-NMR-Signatur, sowie ein zugehöriges Sensor-Handgerät ohne externes Magnetfeld.

CN 204269802 U betrifft eine planare Antenne mit schwacher Kopplung, die in einem Kernquadrupol-Momentresonanz-Detektionssystem eingesetzt wird. Die planare Antenne mit schwacher Kopplung umfasst eine Sendeantenne und eine Empfangsantenne. Die Sendeantenne und die Empfangsantenne sind in der Reihenfolge von außen nach innen angeordnet. Die Sendeantenne und die Empfangsantenne liegen in derselben Ebene. Die Gegeninduktivität zwischen der Sendeantenne und der Empfangsantenne beträgt 0-10 % der Selbstinduktivität der Empfangsantenne. Die Empfangsantenne umfasst eine erste Empfangsantenne und eine zweite Empfangsantenne, die mit der ersten Empfangsantenne verbunden ist. Die erste Empfangsantenne und die zweite Empfangsantenne werden durch gewickelte Drähte gebildet. Die Drahtwickelrichtung der ersten Empfangsantenne ist entgegengesetzt zur Drahtwickelrichtung der zweiten Empfangsantenne. Durch die Gestaltung der Empfangsantenne und der Emissionsantenne kann ein Kernquadrupol-Momentresonanz-Detektionssystem, das mit der planaren Antenne mit schwacher Kopplung ausgestattet ist, stabil ohne elektromagnetische Abschirmung arbeiten. Elektromagnetische Streuwellen können wirksam unterdrückt werden und ein Signal-Rausch-Verhältnis eines NQR-Signals wird verbessert.

Für eine zuverlässige Echtheitsprüfung von Nullfeld-NMR-Sicherheitsmerkmalen müssen allerdings mehrere Schwierigkeiten überwunden werden. So ist das Signal-zu-Rausch Verhältnis (SNR) eine kritische Größe jeder Nullfeld-NMR-Messung und sollte so groß wie möglich sein. Die sogenannte Totzeit $\tau$ bezeichnet die Zeitkonstante, mit der die im Resonanzkreis des Sensors gespeicherte Energie nach einem Anregungspuls abnimmt. Die Totzeit kann von der gleichen Größenordnung wie die Zeitkonstante T2* sein, so dass bei einer langen Totzeit die Detektion des intensiven Anfangsteils eines freien Induktionszerfalls unterdrückt wird. Weiter können durch Ein- oder Auslauf-Effekte eines bewegten Prüflings in den Sensorbereich unerwünschte Artefakte, insbesondere bei der Bestimmung der Zeitkonstanten, auftreten, die für eine zuverlässige Messung minimiert werden müssen. Schließlich müssen auch Störeinflüsse auf die gemessene Signalintensität, die nicht mit der untersuchten Merkmalsmenge korrelieren, möglichst gering gehalten oder ganz vermieden werden.

Ausgehend davon liegt der Erfindung die Aufgabe zugrunde, eine gattungsgemäße Vorrichtung anzugeben, die eine einfache und zuverlässige Echtheitsprüfung von Datenträgern mit Nullfeld-NMR-Sicherheitsmerkmalen erlaubt.

Diese Aufgabe wird durch die Merkmale der unabhängigen Ansprüche gelöst. Weiterbildungen der Erfindung sind Gegenstand der abhängigen Ansprüche.

Gemäß der Erfindung enthält eine gattungsgemäße Vorrichtung eine oder mehrere Anregungsspulen zur Erzeugung von Anregungspulsen für das Nullfeld-NMR-Merkmal, sowie ein Array von mehreren, von den Anregungsspulen unabhängigen und zumindest teilweise nebeneinander angeordneten Empfangsspulen zur ortsaufgelösten Detektion der Signalantwort des Nullfeld-NMR-Merkmals.

Die Anzahl N der Empfangsspulen des Empfangsspulenarrays ist dabei größer als die Anzahl M der Anregungsspulen, und die von den Anregungsspulen überdeckte Fläche $F_A$ überdeckt die von den Empfangsspulen des Empfangsspulenarrays überdeckte Fläche $F_E$ zumindest teilweise, insbesondere vollständig, und übersteigt die Größe dieser Fläche $F_E$.

Die von den Anregungsspulen überdeckte Fläche $F_A$ kann die von den Empfangsspulen überdeckte Fläche $F_E$ insbesondere um mehr als 10%, um mehr als 20%, oder sogar um mehr als 50% übersteigen. Falls vorgesehen ist, dass der flächige Datenträger zur Echtheitsprüfung durch die Vorrichtung transportiert wird, so erfasst die von den Anregungsspulen überdeckte Fläche $F_A$ neben der von den Empfangsspulen überdeckte Fläche $F_E$ vorteilhaft auch die in Transportrichtung vor und/oder hinter der überdeckten Fläche $F_E$ liegenden Flächenbereiche.

Die von einer Oberflächenspule bzw. einem -spulenarray überdeckte Fläche entspricht beispielsweise dem Bereich, in dem im Betrieb oberhalb der Spulenebene ein signifikantes Magnetfeld auftritt, also beispielsweise ein Magnetfeld, dessen Feldstärke über 50% des räumlichen Maximums beträgt. Alternativ kann die von einer Oberflächenspule bzw. einem -spulenarray überdeckte Fläche über eine Einhüllende ihrer / seiner geometrischen Abmessungen definiert werden, also beispielsweise als die kleinste quadratische Fläche, in der alle Leiterbahnen der Spule / des Spulenarrays enthalten sind.

Die Empfangsspulen des Empfangsspulenarrays sind vorteilhaft durch Oberflächenspulen, insbesondere in Form von Leiterschleifen oder Spiralspulen, gebildet. Auch die Anregungsspulen können durch Oberflächenspulen, insbesondere durch Leiterschleifen oder Spiralspulen, gebildet sein.

Die Empfangsspulen des Empfangsspulenarrays weisen jeweils einen Spulenradius von 500 μm oder weniger auf. Die Vorrichtung ist dadurch besonders gut an die Echtheitsprüfung dünner Prüflinge mit einer Dicke von etwa 100 μm angepasst. Die eine oder mehreren Anregungsspulen weisen vorteilhaft einen deutlich größeren Durchmesser, beispielsweise von etwa 5 mm, auf.

Mit Vorteil bildet das Empfangsspulenarray ein eindimensionales oder zweidimensionales Array. Insbesondere kann das Empfangsspulenarray ein lineares (eindimensionales) Nx1-Array bilden, oder ein rechteckiges n x m-Array mit N = n*m darstellen. Die Empfangsspulen können jedoch auch auf den Gitterplätzen eines anderen Gittertyps, beispielsweise eines hexagonalen Gitters, angeordnet sein, oder können auch eine unregelmäßige Anordnung aufweisen. Die Anzahl N der Empfangsspulen beträgt in vorteilhaften Gestaltungen 2 bis 10.

Zur besseren gegenseitigen Entkopplung kann vorgesehen sein, dass die Empfangsspulen des Empfangsspulenarrays einander zumindest teilweise überlappend angeordnet sind.

In einer zweckmäßigen Ausgestaltung enthält die Vorrichtung nur eine einzige Anregungsspule.

Das Empfangsspulenarray enthält in einer vorteilhaften Ausgestaltung zwei oder mehr Unterarrays, deren Empfangsspulen jeweils auf eine feste Empfangsfrequenz ausgelegt sind, wobei vorzugsweise jeweils eine Empfangsspule jedes der zwei oder mehr Unterarrays konzentrisch zueinander angeordnet sind. Enthält das Empfangsspulenarray mehrere Unterarrays, so ist vorteilhaft eine der Anzahl an Unterarrays entsprechende Anzahl an zugehörigen Anregungsspulen vorgesehen.

Vorteilhaft weisen die Unterarrays verschiedene Empfangsfrequenzen auf, was eine multispektrale Messung ermöglicht. Vorteilhaft entsprechen die Resonanzfrequenzen der zugehörigen Anregungsspulen den jeweiligen Empfangsfrequenzen der Unterarrays.

Die Empfangsspulen und/oder die Anregungsspulen sind vorteilhaft jeweils mit einer aktiven Entkopplungseinrichtung zur gegenseitigen Entkopplung versehen.

Mit Vorteil ist vorgesehen, dass die von den Empfangsspulen überdeckte Fläche $F_E$ auf die Größe des zu prüfenden Nullfeld-NMR-Merkmals abgestimmt ist, so dass die überdeckte Fläche $F_E$ die gesamte Breite oder sogar die gesamte Fläche des Nullfeld-NMR-Merkmals überdeckt.

In einer bevorzugten Ausgestaltung ist vorgesehen, dass die Empfangsspulen im Empfangsschaltkreis und/oder die Anregungsspulen im Sendeschaltkreis der Vorrichtung jeweils mit einem Richtkoppler, insbesondere zur Kompensation von Störeinflüssen, wie Verstärker drift oder Pulsimperfektionen, versehen sind.

Gemäß einer vorteilhaften Weiterbildung enthält die Vorrichtung eine zusätzliche Kalibrations-Einzelspule mit einer Referenzprobe, die zumindest teilweise überlappend mit dem Anregungsfeld der einen oder der mehreren Anregungsspulen angeordnet ist.

Die Vorrichtung kann zwei oder mehr Teilanordnungen von Anregungsspulen und Empfangsspulen enthalten, wobei jede Teilanordnung eine einzige Anregungsspule und ein zugeordnetes, überlappendes Array aus mehreren, von der jeweiligen Anregungsspule unabhängigen Empfangsspulen enthält. In den Teilanordnungen ist die von der Anregungsspule überdeckte Fläche ($F_{A,i}$) größer als die von den Empfangsspulen des zugeordneten Empfangsspulenarrays überdeckte Fläche ($F_{E,i}$). Bevorzugt sind die Teilanordnungen identisch zueinander ausgebildet, enthalten also jeweils dieselbe Konfiguration aus Anregungsspule und Empfangsspulen.

In einer vorteilhaften Ausgestaltung definiert die Vorrichtung eine Prüffläche für die zu prüfenden flächigen Datenträger, wobei die Anregungsspulen und die Empfangsspulen des Empfangsspulenarrays auf derselben Seite der Prüffläche angeordnet sind.

In einer alternativen, ebenfalls vorteilhaften Ausgestaltung definiert die Vorrichtung eine Prüffläche für die zu prüfenden flächigen Datenträger, wobei die Anregungsspulen und die Empfangsspulen des Empfangsspulenarrays in geringem Abstand auf gegenüberliegenden Seiten der Prüffläche angeordnet sind.

Die Vorrichtung ist mit Vorteil für die Echtheitsprüfung eines Kernquadrupolresonanz (NQR)-Merkmals oder eines NMR-Merkmals in Ferromagnetika ausgelegt und eingerichtet.

Weitere Ausführungsbeispiele sowie Vorteile der Erfindung werden nachfolgend anhand der Figuren erläutert, bei deren Darstellung auf eine maßstabs- und proportionsgetreue Wiedergabe verzichtet wurde, um die Anschaulichkeit zu erhöhen.

Es zeigen:

Fig. 1 eine schematische Darstellung einer erfindungsgemäßen Prüfvorrichtung zur Echtheitsprüfung von Banknoten,

Fig. 2 in (a) und (b) zwei konkrete Gestaltungen des Sensor-Frontends einer erfindungsgemäßen Prüfvorrichtung,

Fig. 3 in (a) bis (c) einige vorteilhafte konkrete Anordnungen mit M Anregungsspulen und einem Array aus N Empfangsspulen in erfindungsgemäßen Prüfvorrichtungen,

Fig. 4 den Anwendungsfall der Verifikation der Vollständigkeit einer Banknote, die mit einem homogenen, vollflächigen Nullfeld-NMR-Merkmal versehen ist,

Fig. 5 eine statische ortsaufgelöste Messung eines strukturierten Nullfeld-NMR-Merkmals, und

Fig. 6 schematisch Blockschaltbilder der Sendeschaltkreise und Empfangsschaltkreise einer erfindungsgemäßen Vorrichtung.

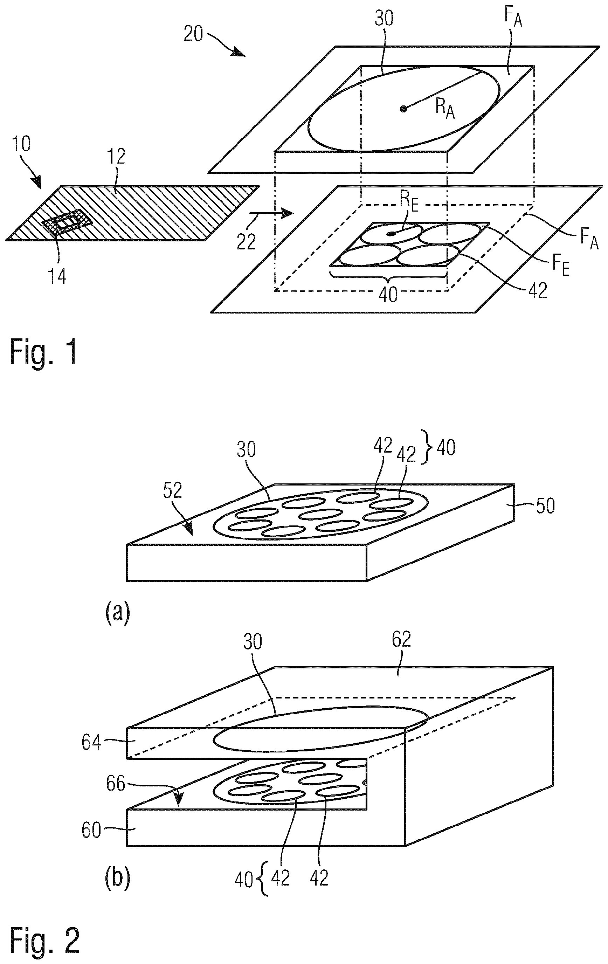

Die Erfindung wird nun am Beispiel der Echtheitsprüfung von Banknoten 10 erläutert. Mit Bezug auf Fig. 1 weisen die zu prüfenden Banknoten 10 ein Nullfeld-NMR-Merkmal auf, das ein die gesamte Fläche der Banknote einnehmendes Merkmal 12 sein kann, oder auch nur in einem bestimmten Merkmalsbereich 14 vorliegen kann. Bei dem Nullfeld-NMR-Merkmal kann es sich insbesondere um ein NQR-Merkmal oder ein NMR-FM-Merkmal handeln.

Zur Echtheitsprüfung werden die Banknotenprüflinge 10 entlang eines Transportpfads 22 durch eine Prüfvorrichtung geführt, von der in Fig. 1 schematisch nur das Sensor-Frontend 20 dargestellt ist. Das Sensor-Frontend 20 enthält zur Erzeugung von Anregungspulsen für das Nullfeld-NMR-Merkmal 12,14 eine einzige Anregungsspule 30 und ein Array 40 aus mehreren, von der Anregungsspule 30 unabhängigen Empfangsspulen 42, mit dem die Signalantwort des Merkmals 12, 14 ortsaufgelöst erfasst werden kann.

Die Empfangsspulen 42 sind im Ausführungsbeispiel jeweils durch planare Mikrospulen mit einem Spulenradius $R_E$ von 500 $\mu$m gebildet und dadurch auf die Prüfung dünner Banknotenprüflinge optimiert. Die Anregungsspule 30 kann beispielsweise einen Spulenradius $R_A$ von 5 mm aufweisen.

In der Figur sind auch die von der Anregungsspule 30 überdeckte Fläche $F_A$ und die von dem Array 40 der Empfangsspulen 42 überdeckte Fläche $F_E$ veranschaulicht. Die von der Anregungsspule 30 überdeckte Fläche $F_A$ überdeckt dabei die von dem Array 40 der Empfangsspulen 42 überdeckte Fläche $F_E$ und übersteigt deren Größe insbesondere im Ein- und Auslaufbereich des Prüflings 10 deutlich.

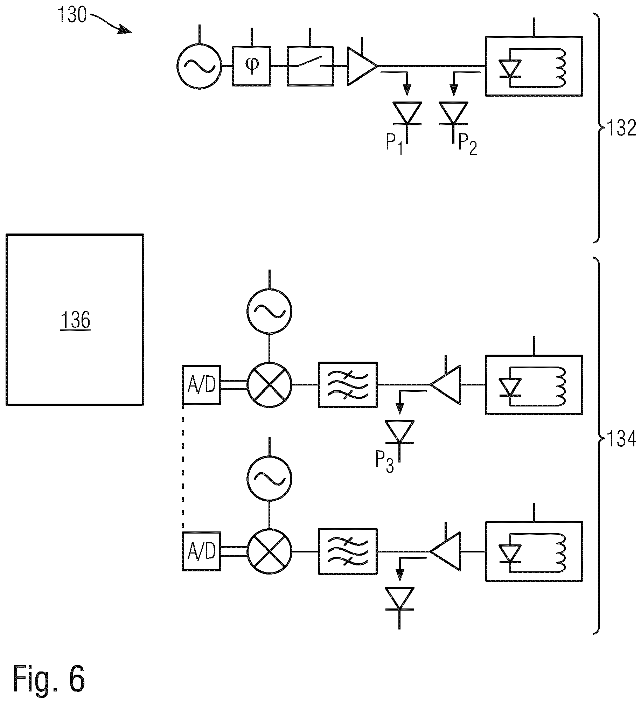

Der Sendeschaltkreis der Anregungsspule 30 und die Empfangsschaltkreise der Empfangsspulen 42 sind jeweils mit einem Richtkoppler (Fig. 6) zur Kompensation von Störeinflüssen, wie etwa eines Verstärkerdrifts oder von Imperfektionen der Sendepulse, versehen. Die Empfangsspulen 42 und gegebenenfalls auch die Anregungsspule 30 sind zudem mit einer aktiven Entkoppelungseinrichtung zur gegenseitigen Entkoppelung (nicht dargestellt) versehen, die beispielsweise auf PIN-Dioden, Kapazitätsdioden oder Hochfrequenz-Schaltern basieren kann.

Die erfindungsgemäße Prüfvorrichtung bietet eine Reihe besonderer Vorteile bei der Echtheitsprüfung flächiger Datenträger, die nunmehr im Detail erläutert werden.

Eine wesentliche Kenngröße gepulster NMR-Messungen ist das Signal-zu-Rausch Verhältnis SNR, für das die Proportionalitätsbeziehung

$$SNR \sim \eta \sqrt{Q}$$

mit dem Füllfaktor $\eta$ und der Güte Q der Empfangsspule gilt. Bei der erfindungsgemäßen Vorrichtung wird das Signal-zu-Rausch Verhältnis insbesondere durch die Anpassung des Füllfaktors $\eta$ optimiert, welcher das Verhältnis der im Proben-Volumen vorhandenen magnetischen Feld-Energie zu der gesamten im Raum vorhandenen magnetischen Feld-Energie der Empfangsspule angibt.

Die Erfinder haben dabei erkannt, dass bei dünnen Prüflingen mit einer Dicke von etwa 100 $\mu$m, wie sie Banknoten oder andere Wertdokumente darstellen, ein großer Füllfaktors $\eta$ und damit ein hohes Signal-zu-Rausch-Verhältnis durch die Ausbildung der Empfangsspulen 42 als Oberflächenspulen mit einem Spulenradius von $R_E$ = 500 $\mu$m oder weniger erreicht werden können.

Bei der erfindungsgemäßen Prüfvorrichtung liefert das Array 40 von kleinen Empfangsspulen 42 durch diesen auf die flächige Probengeometrie der Banknotenprüflinge 10 optimierten Füllfaktor daher zusätzlich zu den weiteren beschriebenen Vorteilen ein deutlich besseres Signal-zu-Rausch-Verhältnis als ein Empfänger aus einer größeren Einzelspule.

Die erfindungsgemäße Gestaltung erlaubt durch die Aufteilung des Sensor-Frontends 20 in eine Anregungsspule 30 und in separate Empfangsspulen 42 auch eine Reduktion der Totzeit $\tau$. Da die Totzeit eines Resonanzkreises - hier eines Empfangsschaltkreises - durch

$$\tau = 2Q/\omega$$

gegeben ist, mit der Güte Q und der Resonanzfrequenz $\omega$, kann die Totzeit durch eine Verringerung der Güte Q verringert werden. Dies steht allerdings im Gegensatz zu dem ebenfalls gewünschten hohen Signal-zu-Rausch-Verhältnis, das proportional zu $\sqrt{Q}$ ansteigt.

Bei der beschriebenen Vorrichtung wird diesen gegenläufigen Anforderungen durch eine aktive Entkoppelung der voneinander getrennten Anregungs- und Empfangsspulen Rechnung getragen. Beispielsweise kann die Resonanzfrequenz $\omega$ einer Empfangsspule 42 während des Anregungspulses mit Hilfe einer Kapazitätsdiode (Varaktordiode) derart verschoben werden, dass der Empfangsspulen-Kreis vom Anregungspuls nicht angeregt wird. Die Totzeit $\tau$ der Empfangsspule 42 ist damit eine Funktion des dynamischen Verhaltens des Schalters und die Güte Q des Empfängers kann unabhängig davon maximiert werden.

Der erfindungsgemäße Aufbau mit getrennten Spulen 30 bzw. 42 für Sender und Empfänger ermöglicht somit eine verringerte Totzeit und damit insbesondere für den freien Induktionszerfall eine höhere Messgenauigkeit als herkömmliche Aufbauten, bei denen dieselben Spulen als Sender und Empfänger dienen.

Ein besonders wertvoller Vorteil der Verwendung eines Arrays 40 aus Empfangsspulen 42 besteht in der erreichbaren Ortsauflösung der Signalantwort. Die Ortsauflösung einer einzelnen Empfangsspule 42 bzw. Empfängerspule 42, also vorliegend der sensitive Bereich einer einzelnen Oberflächenspule 42, ist bei der Nullfeld-NMR umgekehrt proportional zum Spulenradius $R_E$. Der oben genannte kleine Spulenradius von 500 $\mu$m oder weniger führt daher zu einer entsprechend hohen Ortsauflösung, bei der die räumliche Auflösung eines Messpunkts beispielsweise weniger als 1 mm beträgt.

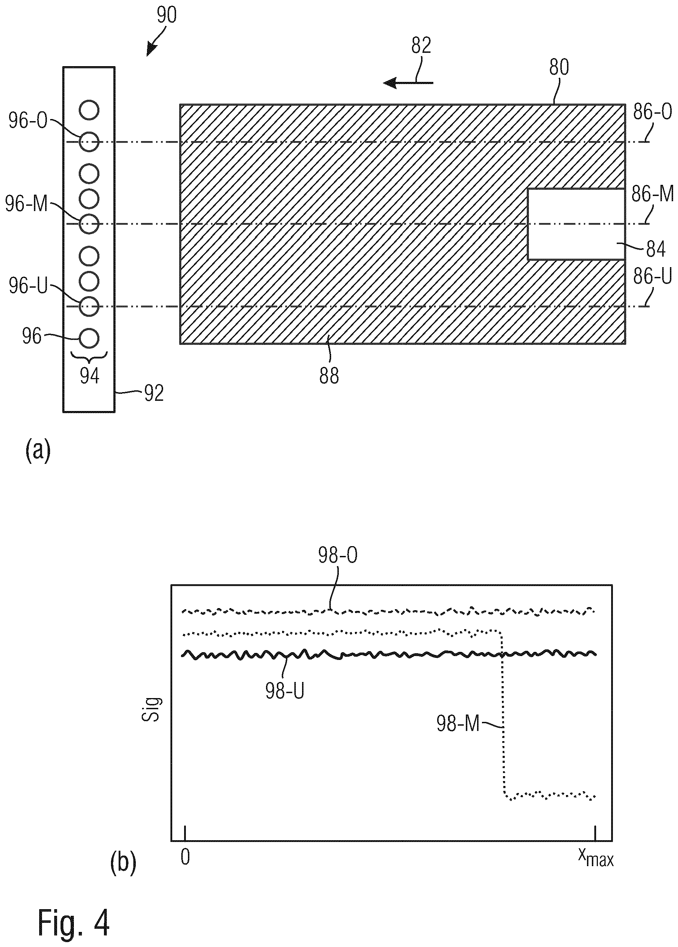

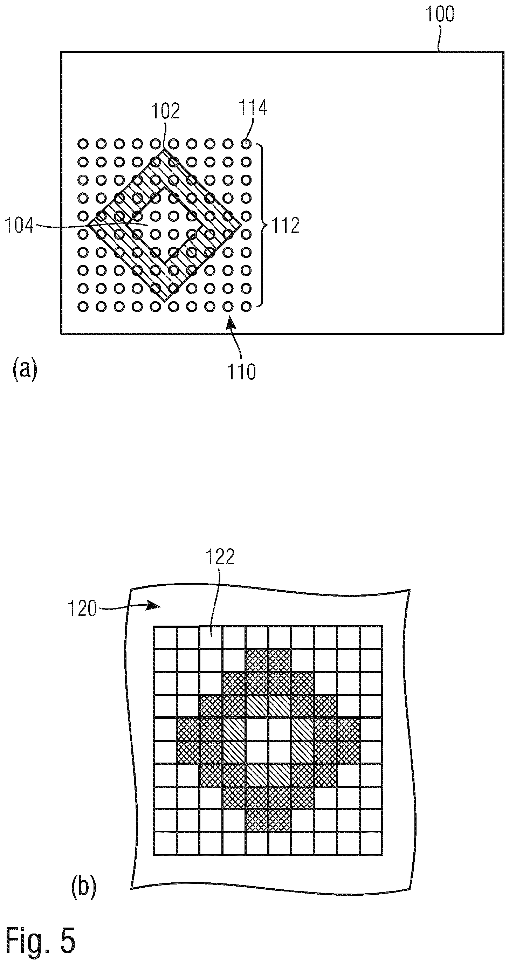

Diese hohe Ortsauflösung erlaubt einerseits die Verifizierung von räumlich codierten Sicherheitsmerkmalen (siehe Fig. 5), sie ist andererseits aber auch bei der Prüfung von großflächig und homogen vorliegenden NMR-Merkmalen vorteilhaft, da sie eine Verifikation der Vollständigkeit eines Prüflings 10 ermöglicht (siehe Fig. 4).

Um den gesamten Prüfling 10 ortsaufgelöst messen zu können, kann das Array 40 aus Empfangsspulen 42 so ausgelegt sein, dass es den gesamten Prüfling abdeckt. Wird der Banknotenprüfling 10 wie in Fig. 1 durch die Prüfvorrichtung 20 transportiert, kann es auch genügen, nur die Probenbreite mit Empfangsspulen 42 abzudecken, da im Zeitfenster eines Durchlaufs der gesamte Prüfling erfasst wird. Bei der Verwendung eines Arrays 40 aus Empfangsspulen können räumliche Kodierungen allerdings auch bei statischen Messungen erkannt und geprüft werden.

Wie an anderer Stelle genauer erläutert, können die Empfangsspulen 42 zur gegenseitigen Entkopplung vorteilhaft überlappen und mit niederimpedanten Empfangsverstärkern versehen werden. Jede Empfangsspule 42 wird dabei vorteilhaft mit einem unabhängigen Empfangszweig beschaltet.

Durch Ein- oder Auslauf-Effekte des Prüflings in den bzw. aus dem sensitiven Bereich des Sensor-Frontends 20 können bei der Messung von bewegten Prüflingen Artefakte, insbesondere bei der Bestimmung der Zeitkonstanten, auftreten. Solche Bewegungsartefakte werden in der vorgeschlagenen Vorrichtung durch ein räumlich homogenes Anregungsfeld unterdrückt. Wie aus Fig. 1 ersichtlich, überdeckt die von der Anregungsspule 30 überdeckte Fläche $F_A$ nicht nur die von den Empfangsspulen 42 des Empfangsspulenarrays überdeckte Fläche $F_E$, sondern auch diejenigen Bereiche des Prüflings 10, die sich während eines Messfensters in den sensitiven Empfangsbereich hinein oder aus diesem hinaus bewegen.

Ein solches homogenes Anregungsfeld wird bei der Ausgestaltung der Fig. 1 durch die Verwendung einer einzigen, großen Anregungsspule 30 erzeugt. Die Verwendung nur einer oder einiger weniger Anregungsspulen ist wegen der erfindungsgemäßen Trennung von Sende- und Empfangsspulen möglich, da für die Anregungsspulen keine Anforderung an den Füllfaktor besteht. Der bei Fig. 1 gezeigte Aufbau mit einer einzigen großen Anregungsspule 30 bietet daher für bewegte Prüflinge 10 signifikante Vorteile gegenüber herkömmlichen Aufbauten mit einem Spulenarray als Anregungsquelle.

Bei der Quantifizierung des Messsignals korreliert die gemessene Signal-Intensität eines Kanals, also die Signal-Intensität einer einzelnen Empfangsspule 42, mit der Merkmalsmenge im Prüfmerkmal, hängt aber auch von der Stärke und Länge des Anregungspulses sowie von den Eigenschaften des Empfangskreises ab.

Zur Kompensation von räumlichen Variationen im Anregungsfeld wird mit Vorteil die Anregungsfeld-Amplitude bei abgeschwächter Sendeleistung bzw. bei abgeschwächter Empfangsverstärkung direkt im laufenden Betrieb mit Hilfe des Arrays 40 der Empfangsspulen 42 bestimmt. Anhand einer solchen Messung kann ein Empfangsspulenindividueller Kompensationsfaktor errechnet werden. Die beschriebenen Gestaltungen ermöglichen eine solche Vorgehensweise, da es sich bei der Anregungsspule 30 und den Empfangsspulen 42 erfindungsgemäß um separate Spulen handelt.

Eine andere Möglichkeit besteht darin, beispielsweise mit Hilfe eines Richtkopplers den Return-Loss der Spulen und etwaige Frequenzdrifts direkt zu bestimmen, um daraus entweder Kompensationsfaktoren zu bestimmen, ein Steuersignal für mögliche Kapazitätsdioden zum Gegensteuern zu generieren, oder aber die Pulslängen und Amplituden der Anregungspulse anzupassen. Zur Kompensation von Temperaturdrifts können Temperatursensoren in den Verstärkerzweigen vorgesehen sein, oder es kann mit Hilfe von Detektor-Dioden die tatsächliche Verstärkung bestimmt und geregelt werden.

Weiter kann das Empfangsspulen-Array vorteilhaft mit einer zusätzlichen Kalibrations-Einzelspule samt einer statischen Referenzprobe versehen werden. Eine solche Kalibrations-Einzelspule soll sich dabei nicht im Prüflings-Pfad 22 befinden, der sensitive Bereich der Kalibrationsspule muss aber mit einem Teil des Anregungsfeldes überlappen. Die gemessenen Signal-Intensitäten in der Kalibrationsspule erlauben dann eine Kompensation von Störeffekten, beispielsweise von Temperaturdrifts des Anregezweiges, auf die am Prüfling 10 gemessenen Intensitäten.

Bei einer Prüfvorrichtung mit einem derart ausgebildeten Sensor-Frontend genügen bei einem geeigneten NMR-Merkmalsstoff bereits Messzeiten unterhalb von 100 ms für eine zuverlässige Echtheitsprüfung eines Prüflings. Mögliche Echtheitskennzeichen sind dabei die Signal-Intensität, die Relaxationszeiten, die spektrale Verteilung der Larmor-Frequenzen, also die Fourier-Transformierte eines Freien-Induktionszerfalls FID oder eines Spin-Echos, und/oder die räumliche Anordnung und Ausbildung des Merkmals.

Figur 2 illustriert zwei konkrete mögliche Gestaltungen des Sensor-Frontends, wobei die verschiedenen Spulen beispielhaft in eine Platine 50 integriert sind. Figur 2(a) zeigt eine Gestaltung mit einer einzelnen Anregungsspule 30 und einem Array 40 aus neun Empfangsspulen 42, die innerhalb der von der Anregungsspule 30 überdeckten Fläche angeordnet sind. Die Empfangsspulen 42 sind dabei in dieselbe Platine 50 wie die Anregungsspule 30 integriert, können aber in einer anderen Kupferebene der Platine 50 ausgebildet sein. Die Oberfläche der Platine 50 definiert eine Prüffläche 52, auf die ein Prüfling aufgelegt werden kann, oder über die ein Prüfling in geringem Abstand transportiert werden kann.

Bei der alternativen Gestaltung der Figur 2(b) enthält das Sensor-Frontend neben einer ersten Platine 60 mit dem Array 40 der neun Empfangsspulen 42 einen Schirm oder Niederhalter 62, der in einer separaten Platine 64 die Anregungsspule 30 trägt. Auch hier sind die neun Empfangsspulen 42 innerhalb der auf die Ebene der Empfangsspulen projizierten Fläche der Anregungsspule 30 angeordnet. Die Oberfläche der ersten Platine 60 definiert eine Prüffläche 66, auf die ein Prüfling aufgelegt werden kann, oder über die ein Prüfling in geringem Abstand transportiert werden kann. Im Gegensatz zu der Gestaltung der Fig. 2(a) sind die Anregungsspule 30 und die Empfangsspulen 42 bei der Gestaltung der Fig. 2(b) nicht auf derselben, sondern auf gegenüberliegenden Seiten der Prüffläche angeordnet.

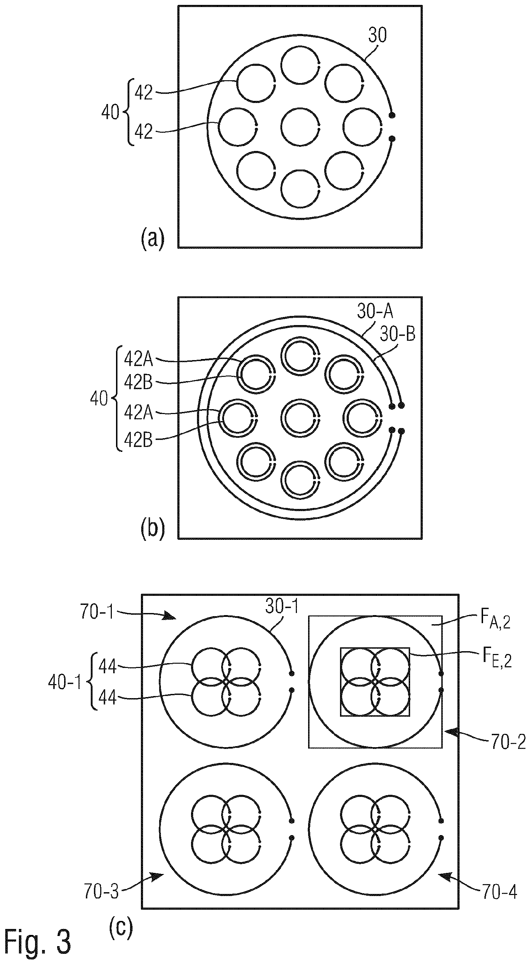

Figur 3 zeigt einige vorteilhafte konkrete Anordnungen mit M Anregungsspulen und einem Array aus N Empfangsspulen in erfindungsgemäßen Prüfvorrichtungen. Die Spulenkonfiguration ist jeweils in Aufsicht dargestellt, wobei die Anregungsspulen und die Empfangsspulen in derselben Ebene oder in verschiedenen Ebenen liegen können und insbesondere auf derselben Seite oder auf gegenüberliegenden Seiten einer Prüffläche für die Prüflinge liegen können, wie in Fig. 2 illustriert.

Zunächst zeigt Fig. 3(a) die bei Fig. 2 verwendete Spulenkonfiguration, bei der das Sensor-Frontend eine einzige Anregungsspule 30 (M = 1) und ein Array 40 aus neun Empfangsspulen 42 (N = 9) enthält. Die Empfangsspulen 42 sind innerhalb der von der Anregungsspule 30 überdeckten Fläche angeordnet und überdecken eine kleinere Fläche als diese.

Figur 3(b) zeigt eine Spulenkonfiguration, bei der das Empfangsspulenarray 40 zwei Unterarrays aus jeweils neun Empfangsspulen 42-A bzw. 42-B enthält, welche jeweils auf eine eigene Resonanzfrequenz $\omega_A$ bzw. $\omega_B$ angepasst sind. Ein erstes Unterarray ist durch die neun Empfangsspulen 42-A, ein zweites Unterarray durch die neun Empfangsspulen 42-B gebildet. Jeweils eine Empfangsspule 42-A und 42-B der beiden Unterarrays sind konzentrisch zueinander angeordnet und elektrisch voneinander entkoppelt. Durch eine entsprechende Beschaltung sind dadurch multispektrale Messungen möglich. Entsprechend sind im Sendeschaltkreis des Sensor-Frontends auch zwei Anregungsspulen 30-A, 30-B vorgesehen, so dass bei diesem Ausführungsbeispiel M = 2 und N = 18 ist. Die Empfangsspulen 42-A, 42-B sind innerhalb der von den Anregungsspulen 30-A, 30-B überdeckten Fläche angeordnet und überdecken eine kleinere Fläche als diese.

Eine weitere Spulenkonfiguration ist in Fig. 3(c) illustriert. Das Sensor-Frontend enthält in diesem Ausführungsbeispiel ein 2 x 2 Raster von Teilanordnungen 70-1, 70-2, 70-3, 70-4, wobei jede Teilanordnung 70-i eine einzige Anregungsspule 30-i und ein zugeordnetes Array 40-i aus von der Anregungsspule 30-i unabhängigen Empfangsspulen 44 enthält. Dabei ist i=1,...4, wobei in der Figur der Übersichtlichkeit halber nur die Anregungsspule 30-1 und das Array 40-1 explizit bezeichnet sind.

Die Empfangsspulen 44 eines jeden Arrays 40-i überlappen sich gegenseitig zur gegenseitigen Entkoppelung. Wie in der Figur dargestellt, ist in jeder Teilanordnung 70-i die von der Anregungsspule 30-i überdeckte Fläche $F_{A,i}$ größer als die von den Empfangsspulen 44 des zugeordneten Empfangsspulenarrays 40-i überdeckte Fläche $F_{E,i}$. Entsprechend ist auch die von den Anregungsspulen 30-i insgesamt überdeckte Fläche größer als die von den Empfangsspulen 44 insgesamt überdeckte Fläche.

In den bisherigen Ausführungsbeispielen sind die Anregungs- und Empfangsspulen beispielhaft als Leiterschleifen dargestellt, es versteht sich aber, dass die Spulen auch spiralförmig oder rechteckig gestaltet sein können. Die verschiedenen Spulen können jeweils auf derselben oder auf verschiedenen Kupferebenen einer Platine oder auf verschiedenen Platinen angeordnet sein. Auch die äußere Umrissform der Empfangsspulen-Arrays kann grundsätzlich eine beliebige Form annehmen.

Figur 4 illustriert als Anwendungsfall die Verifikation der Vollständigkeit einer Banknote, die mit einem homogenen, vollflächigen Nullfeld-NMR-Merkmal 88 versehen ist. Mit Bezug auf Fig. 4(a) wird ein Prüfling 80 entlang der Transportrichtung 82 über ein Sensor-Frontend 90 bewegt, das eine einzige Anregungsspule 92 und ein lineares Array 94 von neun Empfangsspulen 96 umfasst. Im gezeigten Beispiel stellt der Prüfling 80 eine manipulierte Banknote dar, bei der am rechten Rand der Note ein Bereich ausgeschnitten und durch gewöhnliches Papier 84 ohne NMR-Merkmal ersetzt wurde.

Die vorgenommene Manipulation ist aus den in der Fig. 4(b) gezeigten Messdaten des Sensor-Frontends 90 sofort ersichtlich. Dargestellt sind dabei die Messkurven 98-O, 98-M und 98-U für drei Messspuren 86-O, 86-M, 86-U im oberen, mittleren und unteren Teil des Prüflings 80 (Fig. 4), die von drei entsprechend angeordneten Empfangsspulen 96-O, 96-M und 96-U des Sensor-Frontends 90 erfasst wurden.

Die Messkurven 98-O, 98-M, 98-U sind der Übersichtlichkeit halber vertikal um einen konstanten Wert gegeneinander versetzt dargestellt und zeigen jeweils die relative Signalstärke Sig in Abhängigkeit vom Ort x der Signalerfassung entlang der jeweiligen Messspur 86-O, 86-M, 86-U auf dem Prüfling. Durch den Signalabfall der Messkurve 98-M der mittleren Empfangsspule 96-M kann sofort auf das lokale Fehlen des NMR-Merkmals im Bereich 84 des Prüflings 80 und damit auf die Manipulation der Banknote geschlossen werden.

Figur 5 illustriert eine statische ortsaufgelöste Messung eines strukturierten Nullfeld-NMR-Merkmals. Figur 5(a) zeigt hierzu einen kartenförmigen Datenträger 100 mit einem merkmalshaltigen Druckfleck 102 in Form einer Raute mit einer mittigen Aussparung 104. Der Datenträger 100 ist auf die Prüffläche einer erfindungsgemäßen Prüfvorrichtung aufgelegt, deren Sensor-Frontend 110 eine einzige Anregungsspule und ein 10x10-Array 112 von Empfangsspulen 114 enthält. Der Übersichtlichkeit halber ist in der Figur nur das Array 112 mit den durch Ringe angedeuteten Empfangsspulen 114 dargestellt.

Figur 5(b) zeigt das ortsaufgelöste Ergebnis 120 der statischen Messung der Signal-Intensität im Bereich des Druckflecks 102, wobei in jedem Messfeld 122 die von der zugehörigen Empfangsspule 114 nach Anregung erfasste Signalstärke durch die Stärke der Schraffuren dargestellt ist. Durch die Miniaturisierung der Empfangsspulen 114 kann eine hohe Ortsauflösung erreicht werden, so dass die Form des Druckflecks 102 einschließlich der Orientierung der Raute und dem Vorliegen der mittleren Aussparung 104 ohne weiteres erkannt werden kann. Durch eine Abänderung des Druckdesigns ergeben sich daher zahlreiche Möglichkeiten zur Kodierung des Druckflecks 102.

Figur 6 zeigt schematisch Blockschaltbilder der Sendeschaltkreise 132 und Empfangsschaltkreise 134 einer erfindungsgemäßen Vorrichtung 130. Die gesamte Schaltung kann mittels eines Micro-Controllers oder eines FPGAs 136 gesteuert werden. Ein einzelner Sendeschaltkreis enthält eine Frequenzquelle, die im Regelbetrieb auf die Larmor-Frequenz abgestimmt ist, einen Phasenschieber zum Einstellen der korrekten Puls-Phasen und einen Pulsschalter. Im Anschluss folgt ein regelbarer Leistungsverstärker zum Einstellen der Puls-Amplitude. Hinter den Verstärker sind beispielsweise zwei Richtkoppler mit dazugehörigen Detektor-Dioden $P_1$ und $P_2$ geschaltet. Detektor-Diode $P_1$ bestimmt die der jeweiligen Anregungsspule zugeführte Leistung und Detektor-Diode $P_2$ die von der Anregungsspule reflektierte Leistung. Die Anregungsspule selbst wird beispielsweise mit Hilfe einer Varaktordiode in Resonanz gebracht.

Außerhalb einer NMR-Messung kann mit einer solchen Schaltung ein Sweep der Frequenzquelle durchgeführt werden und damit die Frequenzabhängigkeit des Return-Loss (RL) der Anregungsspule mit Hilfe der Detektoren $P_1$ und $P_2$ bestimmt werden. Anhand einer solchen Messung lässt sich die Resonanzfrequenz der Anregungsspule bestimmen und diese mit Hilfe der Varaktordiode auf die Larmor-Frequenz abstimmen. Darüber hinaus kann anhand des Return-Loss die Güte Q der Anregungsspule ermittelt werden.

Um einen Puls mit definiertem Pulswinkel zu erzeugen, das heißt, einen Puls, der die Kernspins der Probe um einen definierten Winkel auslenkt, kann die Pulslänge $\tau$ als Parameter verwendet werden. Die Feldstärke des an der Anregungsspule erzeugten Anregungs-Feldes ist hingegen eine Funktion der Güte Q und der Leistung in der Spule $P_{Spule}$. Letztere Leistung kann beispielsweise mit Hilfe der im Detektor $P_1$ bestimmten Leistung und dem RL berechnet werden. Bei bekannter Güte Q und bekannter Leistung $P_{Spule}$ kann die Pulslänge anhand einer im Controller 136 hinterlegten Kalibrationstabelle oder einem analytischen Zusammenhang flexibel angepasst werden, und so das Messergebnis stabilisiert werden. Alternativ ist es auch denkbar, das Anregungsfeld unter Zuhilfenahme der Empfängerkreise kanalindividuell zu bestimmen.

Jeder der in Fig. 6 gezeigten Empfangsschaltkreise 134 besteht aus einer NMR-Spule, der Empfangsspule, die mit Hilfe einer Varaktordiode in Resonanz gebracht wurde, einem einstellbaren rauscharmen Verstärker und einem Richtkoppler mit Detektor-Diode $P_3$. Schließlich folgt ein Bandpass-Filter sowie ein IQ-Demodulator mit dazugehörigem Local Oscillator (LO) und A/D-Wandler.

Um eine Sättigung des Empfangsschaltkreises zu vermeiden, wird mit Hilfe der Varaktordiode der Empfangskreis nur während des Messfensters in Resonanz geschaltet. Findet im Sendeschaltkreis ein Frequenzsweep statt, so kann die Frequenzabhängigkeit des Return Loss der Empfangsspule mit Hilfe der Dioden $P_1$, $P_2$ und $P_3$ gemessen werden. Dabei werden beispielsweise die Messdaten der Dioden $P_1$ und $P_2$ verwendet, um aus der mit Diode $P_3$ gemessen Frequenzabhängigkeit die Eigenschaften des Sendeschaltkreises herauszurechnen. Anhand der gemessenen Kurve können wiederum die Resonanzfrequenz sowie die Güte Q der Empfangsspule bestimmt werden. Der Wert der Resonanzfrequenz kann dann als Eingangsgröße für die Regelung der Varaktordiode herangezogen werden, und die Güte Q kann zur Korrektur der Signalamplituden verwendet werden.

Bezugszeichenliste

| | |
|---|---|
| 10 | Banknote |
| 12,14 | Nullfeld-NMR-Merkmale |
| 20 | Sensor-Frontend |
| 22 | Transportpfad |
| 30, 30-A, 30-B, 30-i | Anregungsspule |
| 40, 40-i | Array |
| 42, 42-A, 42-B | Empfangsspulen |
| 44 | Empfangsspulen |
| 50 | Platine |
| 52 | Prüffläche |
| 60 | erste Platine |
| 62 | Schirm oder Niederhalter |
| 64 | separate Platine |
| 66 | Prüffläche |
| 70-1, 70-2, 70-3, 70-4 | Teilanordnungen |
| 80 | Prüfling |
| 82 | Transportrichtung |
| 84 | Bereich mit gewöhnlichem Papier |
| 86-O, 86-M, 86-U | Messpuren |
| 88 | Nullfeld-NMR-Merkmal |
| 90 | Sensor-Frontend |
| 92 | Anregungsspule |
| 94 | lineares Array |
| 96, 96-O, 96-M, 96-U | Empfangsspulen |
| 98-O, 98-M, 98-U | Messkurven |
| 100 | kartenförmiger Datenträger |
| 102 | merkmalshaltiger Druckfleck |

| 104 | mittige Aussparung |
|---|---|
| 110 | Sensor-Frontend |
| 112 | Array |
| 114 | Empfangsspulen |
| 120 | Messergebnis |
| 122 | Messfeld |
| 130 | Vorrichtung |
| 132 | Sendeschaltkreise |
| 134 | Empfangsschaltkreise |
| 136 | Micro-Controller / FPGA |

**Patentansprüche**

1. Vorrichtung zur Echtheitsprüfung eines flächigen Datenträgers (10; 100) mit einem Nullfeld-Kernspinresonanz (NMR)-Merkmal (12; 14), insbesondere einem Kernquadrupolresonanz (NQR)-Merkmal und/ oder einem NMR-Merkmal in Ferromagnetika, mit

   - einer oder mehreren Anregungsspulen (30, 30-A, 30-B, 30i) zur Erzeugung von Anregungspulsen für das Nullfeld-NMR-Merkmal (12,14),
   - einem Array (40, 40i) von mehreren, von den Anregungsspulen (30, 30-A, 30-B, 30-i) unabhängigen und zumindest teilweise nebeneinander angeordneten Empfangsspulen (42, 42-A, 42-B; 44; 114) zur ortsaufgelösten Detektion der Signalantwort des Nullfeld-NMR-Merkmals (12; 14), wobei
   - die Anzahl (N) der Empfangsspulen (42, 42-A, 42-B; 44; 114) des Empfangsspulenarrays (40, 40i) größer ist als die Anzahl (M) der Anregungsspulen (30, 30-A, 30-B, 30i),
   - die Empfangsspulen (42, 42-A, 42-B; 44; 114) des Empfangsspulenarrays (40, 40-i) jeweils einen Spulenradius von 500 $\mu$m oder weniger aufweisen, und
   - die von den Anregungsspulen (30, 30-A, 30-B, 30-i) überdeckte Fläche ($F_A$) die von den Empfangsspulen (42, 42-A, 42-B; 44) des Empfangsspulenarrays (40, 40i) überdeckte Fläche ($F_E$) zumindest teilweise überdeckt und die Größe dieser Fläche ($F_E$) übersteigt.

2. Vorrichtung nach Anspruch 1, **dadurch gekennzeichnet, dass** die Empfangsspulen (42, 42-A, 42-B; 44; 114) des Empfangsspulenarrays (40, 40i) durch Oberflächenspulen, insbesondere in Form von Leiterschleifen oder Spiralspulen, gebildet sind.

3. Vorrichtung nach wenigstens einem der Ansprüche 1 oder 2, **dadurch gekennzeichnet, dass** das Empfangsspulenarray (40, 40i) ein eindimensionales oder zweidimensionales Array bildet.

4. Vorrichtung nach wenigstens einem der Ansprüche 1 bis 3, **dadurch gekennzeichnet, dass** die Empfangsspulen (42, 42-A, 42-B; 44; 114) des Empfangsspulenarrays (40, 40i) einander zumindest teilweise überlappend angeordnet sind.

5. Vorrichtung nach wenigstens einem der Ansprüche 1 bis 4, **dadurch gekennzeichnet, dass** das Empfangsspulenarray (40, 40i) zwei oder mehr Unterarrays enthält, deren Empfangsspulen (42, 42-A, 42-B; 44; 114) jeweils auf eine feste Empfangsfrequenz ausgelegt sind, wobei jeweils eine Empfangsspule (42, 42-A, 42-B; 44; 114) der zwei oder mehr Unterarrays vorzugsweise konzentrisch zueinander angeordnet sind.

6. Vorrichtung nach Anspruch 5, **dadurch gekennzeichnet, dass** die Empfangsfrequenzen der Unterarrays verschieden sind.

7. Vorrichtung nach wenigstens einem der Ansprüche 1 bis 6, **dadurch gekennzeichnet, dass** die Empfangsspulen (42, 42-A, 42-B; 44; 114) und/oder die Anregungsspulen (30, 30-A, 30-B, 30-i) jeweils mit einer aktiven Entkoppelungseinrichtung zur gegenseitigen Entkoppelung versehen sind.

8. Vorrichtung nach wenigstens einem der Ansprüche 1 bis 7, **dadurch gekennzeichnet, dass** die von den Empfangsspulen (42, 42-A, 42-B; 44; 114) überdeckte Fläche ($F_E$) auf die Größe des zu prüfenden Nullfeld-NMR-Merkmals (12; 14) abgestimmt ist, so dass die überdeckte Fläche ($F_E$) die gesamte Breite oder sogar die gesamte Fläche des Nullfeld-NMR-Merkmals (12; 14) überdeckt.

9.  Vorrichtung nach wenigstens einem der Ansprüche 1 bis 8, **dadurch gekennzeichnet, dass** die Empfangsspulen (42, 42-A, 42-B; 44; 114) im Empfangsschaltkreis (134) und/ oder die Anregungsspulen (30, 30-A, 30-B, 30-i) im Sendeschaltkreis (132) der Vorrichtung jeweils mit einem Richtkoppler versehen sind.

10. Vorrichtung nach wenigstens einem der Ansprüche 1 bis 9, **dadurch gekennzeichnet, dass** die Vorrichtung eine zusätzliche Kalibrations-Einzelspule mit einer Referenzprobe enthält, die zumindest teilweise überlappend mit dem Anregungsfeld der einen oder mehreren Anregungsspulen (30, 30-A, 30-B, 30-i) angeordnet ist.

11. Vorrichtung nach wenigstens einem der Ansprüche 1 bis 10, **dadurch gekennzeichnet, dass** die Vorrichtung zwei oder mehr Teilanordnungen von Anregungsspulen (30, 30-A, 30-B, 30-i) und Empfangsspulen (42, 42-A, 42-B; 44; 114) enthält, wobei jede Teilanordnung eine einzige Anregungsspule (30, 30-A, 30-B, 30-i)und ein zugeordnetes, überlappendes Array (40, 40i) aus mehreren von der jeweiligen Anregungsspule (30, 30-A, 30-B, 30i) unabhängigen Empfangsspulen (42, 42-A, 42-B; 44; 114) enthält, und wobei in den Teilanordnungen die von der Anregungsspule (30, 30-A, 30-B, 30i) überdeckte Fläche ($F_{A,i}$) größer ist als die von den Empfangsspulen (42, 42-A, 42-B; 44; 114) des zugeordneten Empfangsspulenarrays (40, 40i) überdeckte Fläche ($F_{E,i}$).

12. Vorrichtung nach wenigstens einem der Ansprüche 1 bis 11, **dadurch gekennzeichnet, dass** die Vorrichtung eine Prüffläche (66) für die zu prüfenden flächigen Datenträger (10; 100) definiert, und die Anregungsspulen (30, 30-A, 30-B, 30-i) und die Empfangsspulen (42, 42-A, 42-B; 44; 114) des Empfangsspulenarrays (40, 40i) auf derselben Seite der Prüffläche (66) angeordnet sind.

13. Vorrichtung nach wenigstens einem der Ansprüche 1 bis 11, **dadurch gekennzeichnet, dass** die Vorrichtung eine Prüffläche (66) für die zu prüfenden flächigen Datenträger (10; 100) definiert, und die Anregungsspulen (30, 30-A, 30-B, 30-i) und die Empfangsspulen (42, 42-A, 42-B; 44; 114) des Empfangsspulenarrays (40, 40i) in geringem Abstand auf gegenüberliegenden Seiten der Prüffläche (66) angeordnet sind.

**Claims**

1.  Device for checking the authenticity of a planar data carrier (10; 100) having a zero-field nuclear magnetic resonance (NMR) feature (12; 14), in particular a nuclear quadrupole resonance (NQR) feature and/or an NMR feature in ferromagnetic substances, the device comprising:

    - one or more excitation coils (30, 30-A, 30-B, 30i) for producing excitation pulses for the zero-field NMR feature (12, 14),
    - an array (40, 40i) of a plurality of receiving coils (42, 42-A, 42-B; 44; 114) for the location-resolved detection of the signal response of the zero-field NMR feature (12; 14), which receiving coils are independent of the excitation coils (30, 30-A, 30-B, 30i) and are arranged at least partially adjacent to one another; wherein
    - the number (N) of receiving coils (42, 42-A, 42-B; 44; 114) of the receiving coil array (40, 40i) is greater than the number (M) of excitation coils (30, 30-A, 30-B, 30i),
    - the receiving coils (42, 42-A, 42-B; 44; 114) of the receiving coil array (40, 40-i) each have a coil radius of 500 um or less, and
    - the area ($F_A$) covered by the excitation coils (30, 30-A, 30-B, 30i) at least partially overlaps with the area ($F_E$) covered by the receiving coils (42, 42-A, 42-B; 44) of the receiving coil array (40, 40i) and exceeds the size of said area ($F_E$).

2.  Device according to Claim 1, **characterized in that** the receiving coils (42, 42-A, 42-B; 44; 114) of the receiving coil array (40, 40i) are formed by surface coils, in particular in the form of conductor loops or spiral coils.

3.  Device according to at least one of Claims 1 and 2, **characterized in that** the receiving coil array (40, 40i) forms a one-dimensional or two-dimensional array.

4.  Device according to at least one of Claims 1 to 3, **characterized in that** the receiving coils (42, 42-A, 42-B; 44; 114) of the receiving coil array (40, 40i) are arranged at least partially overlapping one another.

5.  Device according to at least one of Claims 1 to 4, **characterized in that** the receiving coil array (40, 40i) contains two or more sub-arrays, the receiving coils (42, 42-A, 42-B; 44; 114) of which are each configured for a fixed receiving frequency, wherein each receiving coil (42, 42-A, 42-B; 44; 114) of the two or more sub-arrays are preferably arranged concentrically with one another.

6. Device according to Claim 5, **characterized in that** the receiving frequencies of the sub-arrays are different.

7. Device according to at least one of Claims 1 to 6, **characterized in that** the receiving coils (42, 42-A, 42-B; 44; 114) and/or the excitation coils (30, 30-A, 30-B, 30-i) are each provided with an active decoupling apparatus for reciprocal decoupling.

8. Device according to at least one of Claims 1 to 7, **characterized in that** the area ($F_E$) covered by the receiving coils (42, 42-A, 42-B; 44; 114) is matched to the size of the zero-field NMR feature (12; 14) to be checked, such that the covered area ($F_E$) covers the entire width or even the entire area of the zero-field NMR feature (12; 14).

9. Device according to at least one of Claims 1 to 8, **characterized in that** the receiving coils (42, 42-A, 42-B; 44; 114) in the receiving circuit (134) and/or the excitation coils (30, 30-A, 30-B, 30-i) in the transmitting circuit (132) of the device are each provided with a directional coupler.

10. Device according to at least one of Claims 1 to 9, **characterized in that** the device contains an additional single calibration coil having a reference sample which is arranged at least partially overlapping with the excitation field of the one or more excitation coils (30, 30-A, 30-B, 30-i).

11. Device according to at least one of Claims 1 to 10, **characterized in that** the device contains two or more sub-arrangements of excitation coils (30, 30-A, 30-B, 30-i) and receiving coils (42, 42-A, 42-B; 44; 114), wherein each sub-arrangement contains a single excitation coil (30, 30-A, 30-B, 30-i) and an associated, overlapping array (40, 40i) composed of multiple receiving coils (42, 42-A, 42-B; 44; 114) that are independent of the respective excitation coil (30, 30-A, 30-B, 30i), and wherein, in the sub-arrangements, the area ($F_{A,i}$) covered by the excitation coils (30, 30-A, 30-B, 30i) is greater than the area ($F_{E,i}$) covered by the receiving coils (42, 42-A, 42-B; 114) of the associated receiving coil array (40, 40i).

12. Device according to at least one of Claims 1 to 11, **characterized in that** the device defines a check area (66) for the areal data carrier (10; 100) to be checked, and the excitation coils (30, 30-A, 30-B, 30-i) and the receiving coils (42, 42-A, 42-B; 44; 114) in the receiver coil array (40, 40i) are arranged on the same side of the check area (66).

13. Device according to at least one of Claims 1 to 11, **characterized in that** device defines a check area (66) for the areal data carrier (10; 100) to be checked, and the excitation coils (30, 30-A, 30-B, 30-i) and the receiving coils (42, 42-A, 42-B; 44; 114) in the receiving coil array (40, 40i) are arranged at a slight distance on opposite sides of the check area (66).

**Revendications**

1. Dispositif de contrôle de l'authenticité d'un support de données (10 ; 100) sensiblement bidimensionnel pourvu d'une caractéristique de résonance magnétique nucléaire (RMN) à champ nul (12 ; 14), en particulier d'une caractéristique de résonance nucléaire quadripolaire (RQN) et/ou d'une caractéristique RMN dans des substances ferromagnétiques, ledit dispositif comprenant

- une ou plusieurs bobines d'excitation (30, 30-A, 30-B, 30i) destinées à générer des impulsions d'excitation destinées à la caractéristique RMN à champ nul (12, 14),
- un réseau (40, 40i) de plusieurs bobines de réception (42, 42-A, 42-B ; 44 ; 114) indépendantes des bobines d'excitation (30, 30-A, 30-B, 30-i) et disposées au moins partiellement les unes à côté des autres et destinées à effectuer une détection à résolution spatiale de la réponse de signal de la caractéristique RMN à champ nul (12 ; 14),
- le nombre (N) de bobines de réception (42, 42-A, 42-B ; 44 ; 114) du réseau de bobines de réception (40, 40i) étant supérieur au nombre (M) de bobines d'excitation (30, 30-A, 30-B, 30i),
- les bobines de réception (42, 42-A, 42-B ; 44 ; 114) du réseau de bobines de réception (40, 40-i) ayant chacune un rayon de bobine de 500 $\mu$m ou moins, et
- la surface ($F_A$) couverte par les bobines d'excitation (30, 30-A, 30-B, 30-i) recouvrant au moins partiellement la surface ($F_E$) couverte par les bobines de réception (42, 42-A, 42-B ; 44) du réseau de bobines de réception (40, 40i) et dépassant la dimension de cette surface ($F_E$).

**2.** Dispositif selon la revendication 1, **caractérisé en ce que** les bobines de réception (42, 42-A, 42-B ; 44 ; 114) du réseau de bobines de réception (40, 40i) sont formées par des bobines superficielles, notamment sous la forme de boucles de conducteur ou de bobines en spirale.

**3.** Dispositif selon l'une au moins des revendications 1 ou 2, **caractérisé en ce que** le réseau de bobines de réception (40, 40i) forme un réseau unidimensionnel ou bidimensionnel.

**4.** Dispositif selon l'une au moins des revendications 1 à 3, **caractérisé en ce que** les bobines de réception (42, 42-A, 42-B ; 44 ; 114) du réseau de bobines de réception (40, 40i) sont disposées de manière à se chevaucher au moins partiellement.

**5.** Dispositif selon l'une au moins des revendications 1 à 4, **caractérisé en ce que** le réseau de bobines de réception (40, 40i) contient deux sous-réseaux ou plus dont les bobines de réception (42, 42-A, 42-B ; 44 ; 114) sont chacune conçues sur une fréquence de réception fixe, les bobines de réception (42, 42-A, 42-B ; 44 ; 114) des deux sous-réseaux ou plus étant de préférence disposées de manière concentrique l'une à l'autre.

**6.** Dispositif selon la revendication 5, **caractérisé en ce que** les fréquences de réception des sous-réseaux sont différentes.

**7.** Dispositif selon l'une au moins des revendications 1 à 6, **caractérisé en ce que** les bobines de réception (42, 42-A, 42-B ; 44 ; 114) et/ou les bobines d'excitation (30, 30-A, 30-B, 30-i) sont chacune pourvues d'un module de découplage actif destiné à effectuer un découplage mutuel.

**8.** Dispositif selon l'une au moins des revendications 1 à 7, **caractérisé en ce que** la surface ($F_E$) couverte par les bobines de réception (42, 42-A, 42-B ; 44 ; 114) est adaptée à la dimension de la caractéristique RMN à champ nul à tester (12 ; 14) de manière à ce que la surface couverte ($F_E$) couvre toute la largeur voire toute la surface de la caractéristique RMN à champ nul (12 ; 14).

**9.** Dispositif selon l'une au moins des revendications 1 à 8, **caractérisé en ce que** les bobines de réception (42, 42-A, 42-B ; 44 ; 114) dans le circuit de réception (134) et/ou les bobines d'excitation (30, 30-A, 30-B, 30-i) dans le circuit d'émission (132) du dispositif sont chacune pourvues d'un coupleur directionnel.

**10.** Dispositif selon l'une au moins des revendications 1 à 9, **caractérisé en ce que** le dispositif contient une bobine individuelle d'étalonnage supplémentaire pourvue d'une sonde de référence qui est disposée de manière à chevaucher au moins partiellement le champ d'excitation des une ou plusieurs bobines d'excitation (30, 30-A, 30-B, 30-i).

**11.** Dispositif selon l'une au moins des revendications 1 à 10, **caractérisé en ce que** le dispositif contient deux sous-ensembles ou plus de bobines d'excitation (30, 30-A, 30-B, 30-i) et de bobines de réception (42, 42-A, 42-B ; 44 ; 114), chaque sous-ensemble contenant une seule bobine d'excitation (30, 30-A, 30-B, 30-i) et un réseau à chevauchement associé (40, 40i) formé de plusieurs bobines de réception (42, 42-A, 42-B ; 44 ; 114) indépendantes des bobines d'excitation respectives (30, 30-A, 30-B, 30i), et dans les sous-ensembles la surface ($F_{A,i}$) couverte par la bobine d'excitation (30, 30-A, 30-B, 30i) étant supérieure à la surface ($F_{E,i}$) couverte par les bobines de réception (42, 42-A, 42-B ; 44 ; 114) du réseau de bobines de réception associé (40, 40i).

**12.** Dispositif selon l'une au moins des revendications 1 à 11, **caractérisé en ce que** le dispositif définit une surface de test (66) pour les supports de données (10 ; 100) sensiblement bidimensionnels à tester, et les bobines d'excitation (30, 30-A, 30-B, 30-i) et les bobines de réception (42, 42-A, 42-B ; 44 ; 114) du réseau de bobines de réception (40, 40i) sont disposées du même côté de la surface de test (66).

**13.** Dispositif selon l'une au moins des revendications 1 à 11, **caractérisé en ce que** le dispositif définit une surface de test (66) pour les supports de données (10 ; 100) sensiblement bidimensionnels à tester, et les bobines d'excitation (30, 30-A, 30-B, 30-i) et les bobines de réception (42, 42-A, 42-B ; 44 ; 114) du réseau de bobines de réception (40, 40i) sont disposées à une faible distance sur des côtés opposés de la surface de test (66).

Fig. 1

(a)

(b)

Fig. 2

Fig. 3

Fig. 4

100

102    114

104    112

(a)

110

122

120

(b)

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2778705 A1

- CN 204269802 U